# EUROPÄISCHE PATENTANMELDUNG

(11) **EP 4 794 147 A1**
(43) Veröffentlichungstag der Anmeldung: **19.08.2026**
(21) Anmeldenummer: 26153762.5
(22) Anmeldetag: 23.01.2026
(51) Int. Cl.: H02H 1/00, H02H 3/33

(54) **ELEKTRISCHES NETZWERK UND KRAFTFAHRZEUG**

(30) Priorität: 12.02.2025 DE 102025105087
(71) Anmelder: Volkswagen Aktiengesellschaft, 38440 Wolfsburg (DE)
(72) Erfinder: Schwarze, Henrik, 38440 Wolfsburg (DE); Hahn, Erik, 38440 Wolfsburg (DE); Hellmers, Simon Tobias, 38440 Wolfsburg (DE)

(57) **Zusammenfassung**

Die Erfindung betrifft ein elektrisches Netzwerk (1), umfassend einen Master (2) und mindestens eine Steckdose (3), wobei der Master (2) und die mindestens eine Steckdose (3) über Energieleitungen (4) miteinander verbunden sind, wobei im Master (2) in mindestens einer Energieleitung (4) ein Schutzschalter (5) angeordnet ist, wobei der Master (2) und die mindestens eine Steckdose (3) über mindestens eine Busleitung (8) miteinander verbunden sind, wobei im Master (2) mindestens ein Prozessor (6) angeordnet ist, der derart ausgebildet ist, eine Buskommunikation durchzuführen und den mindestens einen Schutzschalter (5) zu betätigen, wobei in der mindestens einen Steckdose (3) mindestens eine Fehlerstromsensorik (10) angeordnet ist, die mit einer Manipulatorschaltung (11) verbunden ist, die derart ausgebildet ist, einen Busfehler zu generieren, wobei der mindestens eine Prozessor (6) derart ausgebildet ist, bei einem erfassten Busfehler den mindestens einen Schutzschalter (5) zu öffnen, sowie ein Kraftfahrzeug (100).

## Beschreibung

Die Erfindung betrifft ein elektrisches Netzwerk und ein Kraftfahrzeug mit einem solchen Netzwerk.

In Regionen mit elektrischen Geräten der Schutzklasse 0 wird für den Einsatz der Funktion "vehicle-to load" der Verbau von Fehlerstromschutzschaltern (auch bekannt als RCD, GFCI oder Fl-Schutzschalter) durch Normen und vom Konzept der elektrischen Sicherheit gefordert. Dies verursacht zusätzlichen Bauraum und Kosten, wobei zusätzlich der Test von in Steckdosen verbauten Fehlerstromschutzschaltern aufwendig ist.

Aus der DE 10 2006 048 073 A1 ist ein elektrischer Schaltkreis zum Betreiben eines Busses eines Feldbussystems bekannt, der Mittel zum Sensieren eines Fehlerstromes aufweist. Die Mittel umfassen erste Mittel zum Bestimmen eines ersten Stromes einer ersten Busleitung, zweite Mittel zum Bestimmen eines zweiten Stromes einer zweiten Busleitung und Mittel zum Detektieren eines Fehlers basierend auf dem ersten Strom und dem zweiten Strom. Dabei sind die Mittel zum Detektieren vorzugsweise derart ausgebildet, um einen Kurzschluss einer Busleitung zu Masse und/oder einen Kurzschluss einer Busleitung zu einer Fremdspannung zu detektieren.

Der Erfindung liegt das technische Problem zugrunde, ein elektrisches Netzwerk mit mindestens einer Steckdose und einem Fehlerstromschutzschalter zu schaffen, das kompakter aufgebaut ist. Ein weiteres Problem ist die Schaffung eines Kraftfahrzeuges mit einem solchen elektrischen Netzwerk.

Die Lösung des technischen Problems ergibt sich durch ein elektrisches Netzwerk mit den Merkmalen des Anspruchs 1 sowie ein Kraftfahrzeug mit den Merkmalen des Anspruchs 10. Weitere vorteilhafte Ausgestaltungen der Erfindung ergeben sich aus den Unteransprüchen.

Das elektrische Netzwerk umfasst einen Master und mindestens eine Steckdose. Der Master und die mindestens eine Steckdose sind über Energieversorgungsleitungen miteinander verbunden. Im Master ist in mindestens einer Energieleitung ein Schutzschalter angeordnet.

Weiter sind der mindestens eine Master und die mindestens eine Steckdose über mindestens eine Busleitung miteinander verbunden. Im Master ist mindestens ein Prozessor angeordnet, der derart ausgebildet ist, eine Buskommunikation durchzuführen und den mindestens einen Schutzschalter zu betätigen. In der mindestens einen Steckdose ist mindestens eine Fehlerstromsensorik angeordnet, die mit einer Manipulatorschaltung verbunden ist, die derart ausgebildet ist, einen Busfehler zu generieren. Der mindestens eine Prozessor im Master ist derart ausgebildet, bei einem erfassten Busfehler den mindestens einen Schutzschalter zu öffnen. Hierdurch kann das Ereignis eines Fehlerstromes sehr schnell an den Master übertragen werden, der dann zentral die Energieübertragung unterdrückt. Dabei ist die Übertragung durch die Generierung des Busfehlers schneller als eine übliche Bus-Nachricht. Vorzugsweise weist das elektrische Netzwerk mehrere Steckdosen auf, beispielsweise 2 bis 8 Steckdosen. Es können aber noch mehr Steckdosen angeschlossen werden. Über die Energieversorgungsleitungen wird vorzugswiese eine Wechselspannung übertragen, wobei Amplitude und Frequenz je nach Land verschieden sein können (z.B. 220 V mit 50 Hz). Vorzugsweise sind zwei Energieversorgungsleitungen vorgesehen, wobei in allen Energieversorgungsleitungen Schutzschalter angeordnet sind, um die Energieversorgung allpolig abzuschalten. Weiter vorzugsweise ist die Fehlerstromsensorik als Ringspule ausgebildet, die sehr robust ist und schnell ein Fehlerstromsignal generiert, das unmittelbar zur Ansteuerung der Manipulatorschaltung verwendet werden kann. Die Manipulatorschaltung ist beispielsweise eine Transistorschaltung, um ein Potential auf der Busleitung zu manipulieren (z.B. auf Masse zu ziehen).

In einer Ausführungsform weist der Master einen Wechselrichter auf, mittels dessen eine Gleichspannung in eine gewünschte Wechselspannung gewandelt werden kann.

In einer Ausführungsform ist der Prozessor im Master derart ausgebildet, bei einem erfassten Busfehler zunächst den Wechselrichter auszuschalten, bevor der mindestens eine Schutzschalter geöffnet wird. Hierdurch wird der mindestens eine Schutzschalter lastfrei geschaltet.

In einer weiteren Ausführungsform weist die mindestens eine Steckdose einen Prozessor auf. Dieser kann verschiedene Aufgaben übernehmen und dient beispielsweise zur Kommunikation mit dem Prozessor des Masters über die mindestens eine Busleitung.

In einer weiteren Ausführungsform ist der mindestens eine Prozessor mit der mindestens einen Fehlerstromsensorik verbunden und derart ausgebildet, ein Fehlerereignis abzuspeichern. So kann beispielsweise nachträglich vom Prozessor des Masters abgefragt werden, welche Steckdose den Fehlerstrom aufwies und die Abschaltung der Energieleitung verursacht hat.

In einer weiteren Ausführungsform ist in der mindestens einen Steckdose mindestens eine Diagnoseschaltung angeordnet, die mit dem Prozessor der Steckdose verbunden ist, wobei die Diagnoseschaltung derart ausgebildet ist, einen Fehlerstrom zu generieren. Hierdurch kann die Fehlerstromsensorik als auch die Funktionsfähigkeit der Schutzschalter überprüft werden. Ein solcher Diagnosemodus wird beispielsweise vom Prozessor des Masters initiiert.

In einer weiteren Ausführungsform ist die Diagnoseschaltung mit mindestens einer Energieleitung verbunden, sodass anschaulich ein Kurzschluss der Energieleitung simuliert wird.

In einer alternativen Ausführungsform ist die Diagnoseschaltung mit einer Gleichspannungsversorgungsleitung verbunden und derart ausgebildet, für Diagnosezwecke einen Gleichstrom durch die Fehlerstromsensorik zu führen. Die Gleichspannungsversorgungsleitung ist beispielsweise eine 12 V-Versorgungsleistung (z.B. KL30), die ohnehin für die Versorgung des Prozessors benötigt wird. Der Vorteil ist, dass die Fehlerströme für Diagnosezwecke sehr klein sind und die Diagnose auch durchgeführt werden kann, wenn die Energieversorgungsleitungen selbst spannungsfrei sind.

In einer weiteren Ausführungsform ist das Bussystem der Busleitung ein LIN-Bussystem, das sehr robust und einfach ist.

Das Kraftfahrzeug weist mindestens ein zuvor beschriebenes elektrisches Netzwerk auf.

Die Erfindung wird nachfolgend anhand bevorzugter Ausführungsbeispiele näher erläutert. Die Figuren zeigen:
- Fig. 1: ein elektrisches Netzwerk in einer ersten Ausführungsform und
- Fig. 2: eine Steckdose in einer zweiten Ausführungsform.

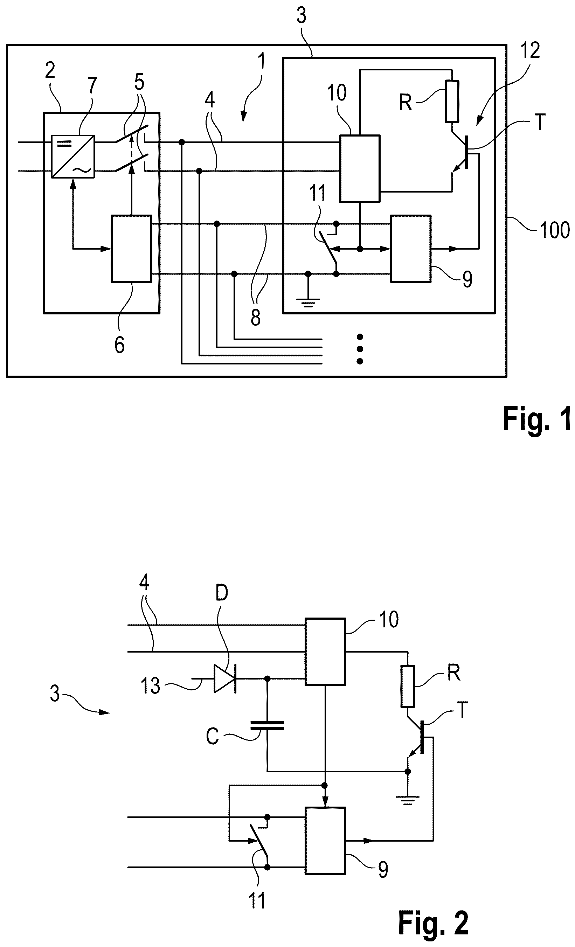

In der Fig. 1 ist ein elektrisches Netzwerk 1 in einem Kraftfahrzeug 100 dargestellt. Das elektrische Netzwerk 1 umfasst einen Master 2 und mindestens eine Steckdose 3, wobei vorzugsweise mehrere Steckdosen 3 vorhanden sind, was durch die Punkte angedeutet ist. Der Master 2 und die Steckdose 3 sind über Energieleitungen 4 miteinander verbunden. Im Master 2 sind Schutzschalter 5 in den Energieleitungen 4 angeordnet, die von einem Prozessor 6 angesteuert werden. Weiter weist der Master 2 einen Wechselrichter 7 auf, der eine Gleichspannung (z.B. von einer Hochvoltbatterie) in eine Wechselspannung gewünschter Frequenz und Amplitude wandelt. Weiter sind der Master 2 und die Steckdose 3 über zwei Busleitungen 8 miteinander verbunden, wobei in der Steckdose 3 ebenfalls ein Prozessor 9 angeordnet ist. Entsprechende Transceiver für die Buskommunikation sind aus Übersichtsgründen nicht dargestellt. Die Steckdose 3 weist eine Fehlerstromsensorik 10 auf, die beispielsweise als Ringspule ausgebildet ist. Die Fehlerstromsensorik 10 ist einerseits mit dem Prozessor 9 und andererseits mit einer Manipulatorschaltung 11 verbunden, wobei die Manipulatorschaltung 11 beispielsweise als Transistor ausgebildet ist, der im durchgeschalteten Zustand die Busleitungen kurzschließt. Weiter ist in der Steckdose 3 eine Diagnoseschaltung 12 angeordnet, die beispielsweise einen Widerstand R und einen Transistor T aufweist. Die Diagnoseschaltung 12 ist mit den Energieleitungen 4 verbunden und wird von dem Prozessor 9 angesteuert.

Ein Grundprinzip der Erfindung ist, dass die Schutzschalter 5 zentral im Master 2 angeordnet sind und zentral bei Fehlerstrom in einer Steckdose 3 auslösen. Die Fehlerstromsensorik 10 ist hingegen dezentral in der jeweiligen Steckdose 3 angeordnet, d.h. jede Steckdose 3 hat ihre eigene Fehlerstromsensorik 10. Aufgrund der Verteilung von Schutzschalter 5 und Fehlerstromsensorik 10 muss nun eine schnelle Kommunikation gewährleistet sein. Dies erfolgt durch die Manipulatorschaltung 11, die die Buskommunikation stört. Die Idee dabei ist, dass eine Störung der Buskommunikation vom Prozessor 6 schneller erfasst wird als die Übertragung einer regulären Busbotschaft. Der einfachste Fall zur Störung ist, die obere Busleitung 8 dauerhaft auf 0 V zu ziehen, da beispielsweise bei den meisten Busprotokollen Vorgaben existieren, wie lange auf beiden Leitungen 0 V anliegen darf. Weisen die Taktsignale auf den Busleitungen beispielsweise Taktzeiten von 50 µs auf und dürfen maximal acht Nullen nacheinander übertragen werden, so erkennt nach 400 µs der Prozessor 6, dass ein Fehler vorliegt. Der Prozessor 6 schaltet dann den Wechselrichter 7 aus und öffnet die Schutzschalter 5, die beispielsweise als Relais (Schütze) ausgebildet sind. Da der Abschaltvorgang des Wechselrichters 7 typischerweise schneller ist, schalten die Schutzschalter 5 lastfrei.

Sind mehrere Steckdosen 3 an den Busleitungen 5 sowie Energieleitungen 4 angeschlossen, so weiß der Master 2 im Fehlerfall nicht, welche Steckdose 3 den Fehlerstrom aufwies. Da aber die Fehlerstromsensorik 10 mit dem Prozessor 9 in seiner Steckdose 3 verbunden ist, dokumentiert dieser die Auslösung. Wenn dann die Manipulatorschaltung 11 wieder öffnet, kann der Prozessor 6 im Master 2 die Prozessoren 9 in den Steckdosen 3 auffordern, ihren Status zu übermitteln (also ob ihre Fehlerstromsensorik 10 angesprochen hat). Diese Information kann dann der Master 2 einer Anzeigeeinheit oder einem anderen Steuergerät übermitteln.

Mittels der Diagnoseschaltung 12 kann die Funktionsfähigkeit der Fehlerstromsensorik 10 als auch der Schutzschalter 5 überprüft werden. Hierzu übermittelt der Wechselrichter 7 ein Diagnosesignal an den Prozessor 6 oder der Prozessor 6 erzeugt dieses eigenständig nach vorgegebenen Kriterien (z.B. nach einer vorgegebenen Zeit oder einer vorgegebenen Betriebsdauer). Der Prozessor 6 überträgt dann das Diagnosesignal an einen Prozessor 9 einer Steckdose 3. Dieser schaltet dann den Transistor T an, sodass ein Teil des Stromes durch den Transistor T abfließt, also ein künstlicher Fehlerstrom erzeugt wird. Die Fehlerstromsensorik 10 steuert dann im fehlerfreien Zustand die Manipulatorschaltung 11 an, was vom Prozessor 6 erfasst wird. Dies kann nacheinander mit allen angeschlossenen Steckdosen 3 wiederholt werden.

In der Fig. 2 ist eine alternative Ausführungsform einer Steckdose 3 dargestellt, wobei der einzige Unterschied die Ausbildung der Diagnoseschaltung 12 ist. Die Diagnoseschaltung 12 weist eine Diode D, einen Kondensator C, einen Widerstand R und einen Transistor T auf, wobei der Transistor T vom Prozessor 9 angesteuert wird. Die Diode D ist mit einer Gleichspannungsversorgungsleitung 13 verbunden, die beispielsweise 12 V Gleichspannung aufweist (KL30) und die Versorgungsspannung für den Prozessor 9 zur Verfügung stellt. Die Gleichspannungsversorgungsleitung 13 wird über die Diode D durch die Fehlerstromsensorik 10 geführt und von dort über den Widerstand R und den Transistor T nach Masse. Des Weiteren wird die Gleichspannungsversorgungsleitung 13 hinter der Diode D und vor der Fehlerstromsensorik 10 über den Kondensator C nach Masse geführt. Im Normalbetrieb sperrt der Transistor T und es fließt kein Gleichstrom durch die Fehlerstromsensorik 10. Im Diagnosemodus wird der Transistor T aufgesteuert und es fließt ein Gleichstrom durch die Fehlerstromsensorik 10 und diese steuert dann die Manipulatorschaltung 11 an.

### Bezugszeichenliste

- 1: Netzwerk
- 2: Master
- 3: Steckdose
- 4: Energieleitung
- 5: Schutzschalter
- 6: Prozessor
- 7: Wechselrichter
- 8: Busleitung
- 9: Prozessor
- 10: Fehlerstromsensorik
- 11: Manipulatorschaltung
- 12: Diagnoseschaltung
- 13: Gleichspannungsversorgungsleitung
- 100: Kraftfahrzeug
- C: Kondensator
- D: Diode
- R: Widerstand
- T: Transistor

## Patentansprüche

1. Elektrisches Netzwerk (1), umfassend einen Master (2) und mindestens eine Steckdose (3), wobei der Master (2) und die mindestens eine Steckdose (3) über Energieleitungen (4) miteinander verbunden sind, wobei im Master (2) in mindestens einer Energieleitung (4) ein Schutzschalter (5) angeordnet ist, wobei der Master (2) und die mindestens eine Steckdose (3) über mindestens eine Busleitung (8) miteinander verbunden sind, wobei im Master (2) mindestens ein Prozessor (6) angeordnet ist, der derart ausgebildet ist, eine Buskommunikation durchzuführen und den mindestens einen Schutzschalter (5) zu betätigen, wobei in der mindestens einen Steckdose (3) mindestens eine Fehlerstromsensorik (10) angeordnet ist, die mit einer Manipulatorschaltung (11) verbunden ist, die derart ausgebildet ist, einen Busfehler zu generieren, wobei der mindestens eine Prozessor (6) derart ausgebildet ist, bei einem erfassten Busfehler den mindestens einen Schutzschalter (5) zu öffnen.

2. Elektrisches Netzwerk nach Anspruch 1, **dadurch gekennzeichnet, dass** der Master (2) einen Wechselrichter (7) aufweist.

3. Elektrisches Netzwerk nach Anspruch 2, **dadurch gekennzeichnet, dass** der mindestens eine Prozessor (6) derart ausgebildet ist, bei einem erfassten Busfehler zunächst den Wechselrichter (7) auszuschalten, bevor der mindestens eine Schutzschalter (5) geöffnet wird.

4. Elektrisches Netzwerk nach einem der vorangegangenen Ansprüche, **dadurch gekennzeichnet, dass** die mindestens eine Steckdose (3) einen Prozessor (9) aufweist.

5. Elektrisches Netzwerk nach Anspruch 4, **dadurch gekennzeichnet, dass** der mindestens eine Prozessor (9) mit der mindestens einen Fehlerstromsensorik (10) verbunden ist und derart ausgebildet ist, ein Fehlerereignis abzuspeichern.

6. Elektrisches Netzwerk nach einem der Ansprüche 4 oder 5, **dadurch gekennzeichnet, dass** in der mindestens einen Steckdose (3) mindestens eine Diagnoseschaltung (12) angeordnet ist, die mit dem Prozessor (9) verbunden ist, wobei die Diagnoseschaltung (12) derart ausgebildet ist, einen Fehlerstrom zu generieren.

7. Elektrisches Netzwerk nach Anspruch 6, **dadurch gekennzeichnet, dass** die Diagnoseschaltung (12) mit mindestens einer Energieleitung (4) verbunden ist.

8. Elektrisches Netzwerk nach Anspruch 6, **dadurch gekennzeichnet, dass** die Diagnoseschaltung (12) mit einer Gleichspannungsversorgungsleitung (13) verbunden ist und derart ausgebildet ist, für Diagnosezwecke einen Gleichstrom durch die Fehlerstromsensorik (10) zu führen.

9. Elektrisches Netzwerk nach einem der vorangegangenen Ansprüche, **dadurch gekennzeichnet, dass** das Bussystem der Busleitung (8) ein LIN-Bussystem ist.

10. Kraftfahrzeug (100), wobei das Kraftfahrzeug (100) ein elektrisches Netzwerk (1) nach einem der Ansprüche 1 bis 9 aufweist.
